# EUROPEAN PATENT APPLICATION

(11) **EP 3 852 150 A1**
(43) Date of publication of application: **21.07.2021**
(21) Application number: 19868879.8
(22) Date of filing: 12.09.2019
(51) Int. Cl.: H01L 31/043, H01L 31/05

(54) **PHOTOVOLTAIC DEVICE AND PHOTOVOLTAIC MODULE**

(30) Priority: 02.10.2018 JP 2018187564
(71) Applicant: KANEKA CORPORATION, Osaka 530-8288 (JP)
(72) Inventor: TERASHITA Toru, Settsu-shi, Osaka 566-0072 (JP); NAKAMURA Junichi, Settsu-shi, Osaka 566-0072 (JP); KOJIMA Kohei, Settsu-shi, Osaka 566-0072 (JP)
(74) Representative: Hoffmann Eitle
(86) International application number: PCT/JP2019/035888
(87) International publication number: WO 2020/071083

(57) **Abstract**

Provided is a photovoltaic device with which it is possible to achieve an increase in output and an improvement in design. A photovoltaic device 1 is provided with a plurality of photovoltaic cells 2. Of adjacent photovoltaic cells among the plurality of photovoltaic cells, part of one photovoltaic cell 2 on one main surface side on one end side overlaps under part of the other photovoltaic cell 2 on the other main surface side on the other end side. The photovoltaic cells 2 are back junction type photovoltaic cells including a p-type semiconductor layer 25 and an n-type semiconductor layer 35 which are formed on the other main surface side of a semiconductor substrate 11. The p-type semiconductor layer 25 and the n-type semiconductor layer 35 include a plurality of branch pattern parts 25f and 35f and trunk pattern parts 25b and 35b, respectively. The trunk pattern part 25b of the p-type semiconductor layer 25 is arranged on the one end side of the photovoltaic cell 2, and part or all of the trunk pattern part 25b of the p-type semiconductor layer 25 is arranged in an overlapping region Ro in which the adjacent photovoltaic cells partially overlap with each other.

## Description

### TECHNICAL FIELD

The present invention relates to a solar cell device and a solar cell module including the solar cell device.

### BACKGROUND ART

A current method for assembling double-sided electrode-type solar cells into a module includes overlapping portions of solar cells to directly, electrically, and mechanically connect them without using any electrically-conductive connecting wires. Such a connection method is called a shingling process, and a plurality of solar cells electrically connected using the shingling process is called a solar cell string (solar cell device) (see, for example, Patent Document 1) .

The solar cell string (solar cell device) allows more solar cells to be mounted on a limited area in a solar cell module, which increases the light receiving area for photoelectric conversion and increases the power of the solar cell module. Moreover, the solar cell string (solar cell device) has no space between solar cells, which improves the design of the solar cell module.

Patent Document 1: Japanese Unexamined Patent Application, Publication No. 2017-517145

### DISCLOSURE OF THE INVENTION

### Problems to be Solved by the Invention

In order to improve power and design also in a case where back electrode-type solar cells are assembled into a module, there is a study on using a shingling process to overlap and connect portions of the solar cells. A need exists for further improvement of the power of a solar cell device or module including back electrode-type solar cells partially overlapped using such a shingling process.

It is an object of the present invention to provide a solar cell device with improved power and improved design and to provide a solar cell module including such a solar cell device.

### Means for Solving the Problems

The present invention is directed to a solar cell device including a plurality of solar cells connected electrically, adjacent solar cells of the plurality of solar cells being overlapped in such a manner that a portion of one of the adjacent solar cells, which is at one end portion and on one main surface, is disposed under a portion of another of the adjacent solar cells, which is at another end portion opposite to the one end portion and on another main surface opposite to the one main surface, each of the plurality of solar cells being a back junction solar cell including: a semiconductor substrate; a p-type semiconductor layer provided in a portion on the another main surface of the semiconductor substrate; and an n-type semiconductor layer provided in another portion on the another main surface of the semiconductor substrate, each of the p-type semiconductor layer and the n-type semiconductor layer including a plurality of branch pattern portions and a stem pattern portion to which an end of each of the branch pattern portions is connected, the stem pattern portion of the p-type semiconductor layer being disposed at the one end portion of each of the solar cells, the stem pattern portion of the p-type semiconductor layer being partially or entirely disposed in an overlap region in which portions of the adjacent solar cells overlap.

The present invention is also directed to a solar cell module including the solar cell device recited above.

### Effects of the Invention

The present invention makes it possible to provide a solar cell module with improved power and improved design.

### BRIEF DESCRIPTION OF THE DRAWINGS

FIG. 1 is a bottom view of a solar cell module including a solar cell device according to the present embodiment;
FIG. 2 is a cross-sectional view of the solar cell module along the line II-II shown in FIG. 1;
FIG. 3 is a bottom view of a solar cell in the solar cell device shown in FIGS. 1 and 2;
FIG. 4A is a cross-sectional view of the solar cell along the line IVA-IVA shown in FIG. 3;
FIG. 4B is a cross-sectional view of the solar cell along the line IVB-IVB shown in FIG. 3;
FIG. 5A is an enlarged cross-sectional view of a portion at and near an overlap region of the solar cell device shown in FIG. 2, which is substantially along the line IVA-IVA shown in FIG. 3;
FIG. 5B is an enlarged cross-sectional view of a portion at and near an overlap region of the solar cell device shown in FIG. 2, which is substantially along the line IVB-IVB shown in FIG. 3; and
FIG. 6 is a graph showing the results of measurement of the current output from solar cell modules according to Example 1 and Comparative Example 1.

### PREFERRED MODE FOR CARRYING OUT THE INVENTION

Hereinafter, an example according to an embodiment of the present invention will be described with reference to the accompanying drawings. Throughout the drawings, the same reference signs are used to indicate the same or corresponding components. In some drawings, hatching, reference signs, or the like are omitted for the sake of simplicity, which can be compensated for by referring to other drawings.

### Outline

In general, a solar cell is fabricated using a large semiconductor substrate (e.g., substantially square) of a predetermined size (e.g., 6 inches). Since such a large semiconductor substrate is expensive, a conventional technique involves efficiently using as much of the surface of the large semiconductor substrate as possible, as close to the edge as possible. Specifically, electrodes are formed as close as possible to the edge of the large semiconductor substrate so that a current generated by photoelectric conversion near the edge of the large semiconductor substrate can be efficiently used.

However, the present inventors have found that the photoelectric conversion efficiency is lower at a portion near the edge of the large semiconductor substrate than at its inner portion. The present inventors have also found that the photoelectric conversion efficiency is lower in a p-type semiconductor region than in an n-type semiconductor region.

Large semiconductor substrates are expected to come down in price in the future. If so, it may be considered effective not to use as much of the surface of the large semiconductor substrate as possible, as close to its edge as possible. For example, a shingling process may be used to overlap and connect portions of a plurality of solar cells so that a larger inner area of each large semiconductor substrate can be used for mounting.

Thus, the present inventors propose that solar cells should be overlapped in such a manner that a near-edge portion of one solar cell is disposed under a near-edge portion of another adjacent solar cell so that the near-edge portion of the large semiconductor substrate will be shielded from light so as not to contribute to photoelectric conversion. The present inventors further propose that a p-type semiconductor region, which provides a photoelectric conversion efficiency lower than that provided by an n-type semiconductor region, should be disposed at the near-edge portion shielded from light.

### Solar Cell Module

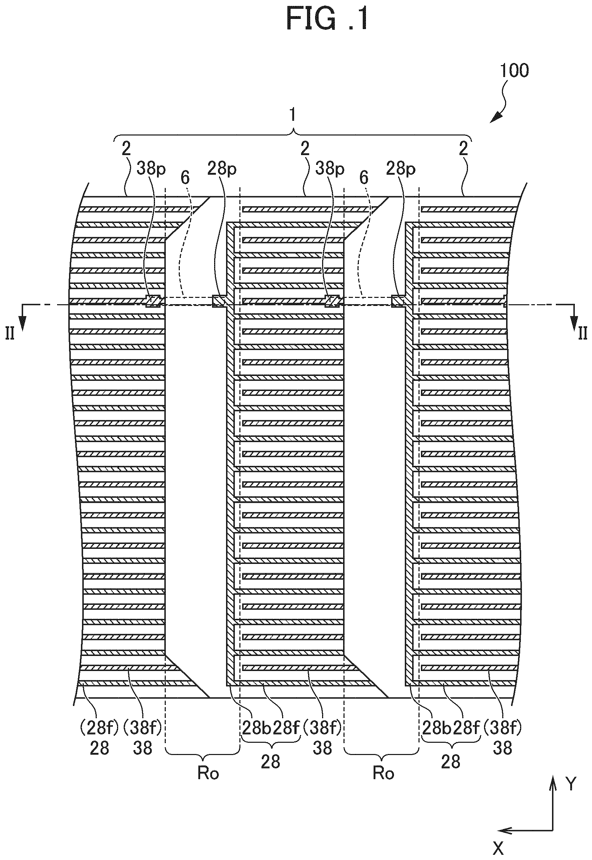

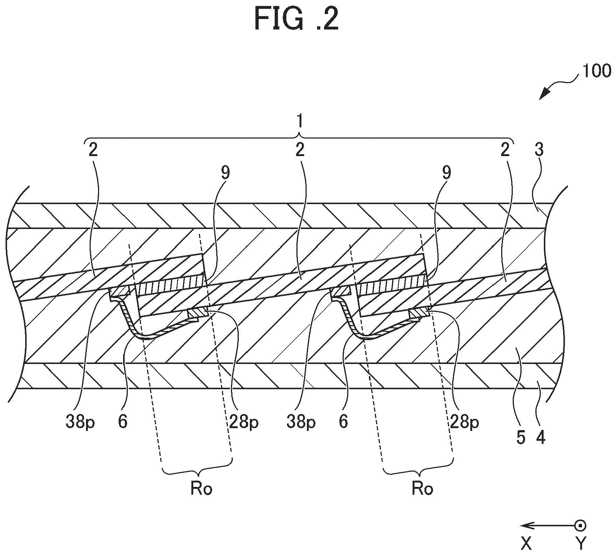

FIG. 1 is a bottom view of a solar cell module including a solar cell device according to the present embodiment. FIG. 2 is a cross-sectional view of the solar cell module along the line II-II shown in FIG. 1. FIG. 1 shows a connecting member 6 (described later) in a see-through manner, and a light receiving side protective member 3, a back side protective member 4, and a sealant 5, which will be described later, are omitted from FIG. 1. FIGS. 1 and 2 show a solar cell module 100 including a solar cell device (also referred to as a solar cell string) 1 including a plurality of rectangular, back electrode-type (back junction) solar cells 2, which are electrically connected using a shingling process.

The solar cell device 1 is disposed between a light receiving side protective member 3 and a back side protective member 4. A liquid or solid sealant 5 is filled between the light receiving side protective member 3 and the back side protective member 4 to seal the solar cell device 1.

The sealant 5 seals and protects the solar cell device 1, namely, the solar cells 2. The sealant 5 is provided between the light receiving surfaces of the solar cells 2 and the light receiving side protective member 3 and between the back surfaces of the solar cells 2 and the back side protective member 4. The sealant 5 may be in any shape, such as a sheet shape. The sealant 5 in the form of a sheet can easily cover the top and bottom surfaces of the solar cells 2, which are planar. While the sealant 5 may be made of any material, the sealant 5 preferably has a light transmitting property (optical transparency). The sealant 5 is also preferably made of an adhesive material capable of bonding the solar cells 2, the light receiving side protective member 3, and the back side protective member 4 together. Examples of such a material include optically transparent resins, such as ethylene-vinyl acetate copolymers (EVA), ethylene-α-olefin copolymers, ethylene-vinyl acetate-triallyl isocyanurate copolymers (EVAT), polyvinyl butyrate (PVB), acrylic resins, urethane resins, or silicone resins.

The light receiving side protective member 3 covers the solar cell device 1, namely, the surfaces (light receiving surfaces) of the solar cells 2 to protect the solar cells 2 with the sealant 5 in between the protective member 3 and the solar cells 2. The light receiving side protective member 3 may be in any shape. In order to cover the planar light receiving surface indirectly, the protective member 3 is preferably in the form of a plate or a sheet. The light receiving side protective member 3 may be made of any material. Like the sealant 5, the protective member 3 is preferably made of an optically-transparent, ultraviolet-resistant material, such as glass or transparent resin such as acrylic or polycarbonate resin. The surface of the light receiving side protective member 3 may be processed to have a protruding and recessed pattern or may be covered with an antireflection coating layer. Such a modification makes the light receiving side protective member 3 less reflective to incident light so that more light can be introduced into the solar cell device 1.

The back side protective member 4 covers the solar cell device 1, namely, the back surfaces of the solar cells 2 to protect the solar cells 2 with the sealant 5 in between the protective member 4 and the solar cells 2. The back side protective member 4 may be in any shape. Like the light receiving side protective member 3, the protective member 4 is preferably in the form of a plate or a sheet in order to cover the planar back surfaces indirectly. The back side protective member 4 may be made of any material. Preferably, the protective member 4 is made of a material capable of preventing infiltration of water and the like (highly water-impermeable material). For example, such a material may be a film of resin, such as polyethylene terephthalate (PET), polyethylene (PE), olefin resin, fluororesin, or silicone-containing resin, or a laminate of a metal foil, such as an aluminum foil, and an optically transparent sheet such as a glass sheet or a sheet of resin, such as polycarbonate or acrylic resin.

### Solar Cell Device

In the solar cell device 1, end portions of the solar cells 2 are partially overlapped so that the solar cells 2 are connected in series. Specifically, a portion of one of the adjacent solar cells 2, which is at one end portion (e.g., the left end portion in FIG. 2) in the X direction of the solar cell 2 and on one main surface (e.g., the light receiving surface), is disposed under a portion of another of the adjacent solar cells 2, which is at another end portion in the X direction of the solar cell 2 (another end portion opposite to the above one end portion, e.g., the right end portion in FIG. 2) and on another main surface (another main surface opposite to the above one main surface, e.g., the back surface). Each solar cell 2 has a pad electrode 28p (described later) at its one end portion on its back side and has a pad electrode 38p (described later) at its another end portion on its back side. The pad electrode 28p at one end portion on the back side of one of the solar cells 2 is electrically connected via a connecting member 6 to the pad electrode 38p at another end portion on the back side of another of the solar cells 2.

Thus, like tiles on a roof, the plurality of solar cells 2 are deposited to form a structure in which they are uniformly inclined in a certain direction. Thus, the method of electrically connecting the solar cells 2 in such a manner is referred to as the shingling process. The plurality of solar cell cells 2 connected in a string configuration is referred to as a solar cell string (solar cell device). As mentioned above, no electrically-conductive connecting wire is necessary when the shingling process is used to overlap and connect portions of double-sided electrode-type solar cells. On the other hand, electrically-conductive connecting wires (e.g., connecting members 6) are necessary for connecting pad electrodes when the shingling process is used to overlap and connect portions of back electrode-type solar cells. Therefore, the term "shingling process" refers to a method of overlapping and connecting portions of solar cells regardless of using or not using electrically-conductive connecting wires. Hereinafter, the region in which the adjacent solar cells 2 overlap will be referred to as the overlap region Ro.

Each connecting member 6 is provided across the adjacent solar cells 2 to electrically connect the adjacent solar cells 2. In the X direction, the connecting member 6 has one end portion (e.g., right end portion in FIG. 2) electrically connected to the pad electrode 28p at one end portion in the X direction (e.g., left end portion in FIG. 2) on the back side of one of the solar cells 2. In the X direction, the connecting member 6 has another end portion (e.g., left end portion in FIG. 2) electrically connected to the pad electrode 38p at another end portion in the X direction (e.g., right end portion in FIG. 2) on the back side of another of the solar cells 2.

A method for electrically connecting the adjacent solar cells 2 may include placing a connecting member between a light receiving surface-side one end portion of one solar cell 2 and a back surface-side of another end portion of the other solar cell 2 to directly connecting them in the overlap region Ro. In this embodiment, however, end face portions of the solar cells 2 are not directly connected in such a manner. This increases the degree of freedom in the design of the electrode of the back electrode-type solar cell 2.

The connecting member 6 may be a ribbon wire including a copper core material coated with a low melting point metal, tin, or solder; a braided wire having a flat cross-sectional shape and including a plurality of metal strands twisted together; or a foil material including a copper-based material and having a thickness of 10 µm or more and 50 µm or less. The connecting member 6 and the pad electrode 28p or 38p may be connected using an electrically-conductive film including a thermosetting resin film containing low melting point metal particles or metal fine particles; an electrically-conductive adhesive including a binder and low melting point metal particles or metal fine particles; or a solder paste containing solder particles. An example of such a material for the connecting member 6 may be a Ag or Cu paste containing an epoxy resin or an oligomer component such as urethane acrylate.

In the overlap region Ro, an insulating member 9 may be provided between the adjacent solar cells 2. The details of the solar cell device 1 will be described later. Hereinafter, the solar cell 2 in the solar cell device 1 will be described.

### Solar Cell

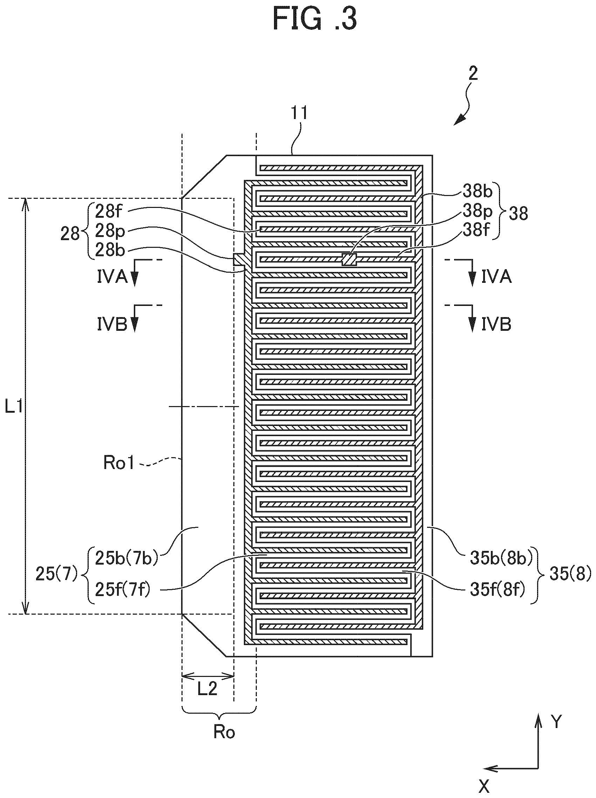

FIG. 3 is a bottom view of the solar cell 2 in the solar cell device 1 shown in FIGS. 1 and 2. The solar cell 2 shown in FIG. 3 is a rectangular, back electrode-type (back junction) solar cell. The solar cell 2 includes a semiconductor substrate 11 having two main surfaces, one on one side (e.g., the light receiving side) and the other on the opposite side (e.g., the back side), and also includes a p-type region (first conductivity type region) 7 and an n-type region (second conductivity type region) 8 each on the other main surface of the semiconductor substrate 11.

The p-type region 7 has a so-called comb-shaped structure, which includes a plurality of teeth 7f, which are like teeth of a comb, and a comb back portion 7b, which is like a support for the teeth of a comb. The comb back portion 7b extends in the Y direction (second direction) along one side of the semiconductor substrate 11, and the teeth 7f extend from the comb back portion 7b in the X direction (first direction) intersecting the Y direction. Similarly, the n-type region 8 has a so-called comb-shaped structure, which includes a plurality of teeth 8f, which are like teeth of a comb, and a comb back portion 8b, which is like a support for the teeth of a comb. The comb back portion 8b extends in the Y direction along another opposite side of the semiconductor substrate 11, and the teeth 8f extend from the comb back portion 8b in the X direction. The teeth 7f and 8f are provided alternately in the Y direction. Alternatively, the p-type region 7 and the n-type region 8 may be formed in a stripe pattern.

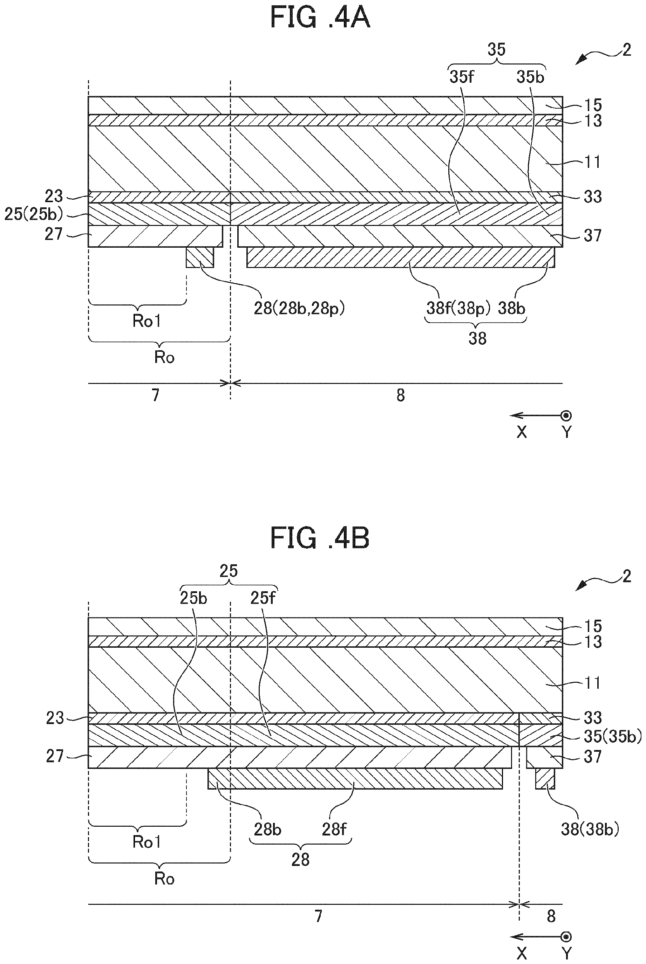

FIG. 4A is a cross-sectional view of the solar cell 2 along the line IVA-IVA shown in FIG. 3. FIG. 4B is a cross-sectional view of the solar cell 2 along the line IVB-IVB shown in FIG. 3. As shown in FIGS. 4A and 4B, the solar cell 2 includes a passivation layer 13 and an antireflection layer 15, which are stacked in order on the light receiving surface, which is one of the main surfaces of the semiconductor substrate 11 on the light receiving side. The solar cell 2 also includes a passivation layer 23, a p-type semiconductor layer (first conductivity type semiconductor layer) 25, a transparent electrode layer 27, and a first electrode layer 28, which are stacked in order on a portion (mainly, the p-type region 7) of the back surface, which is the other of the main surfaces of the semiconductor substrate 11 on the side opposite to the light receiving side. The solar cell 2 further includes a passivation layer 33, an n-type semiconductor layer (second conductivity type semiconductor layer) 35, a transparent electrode layer 37, and a second electrode layer 38, which are stacked in order on another portion (mainly, the n-type region 8) of the back surface of the semiconductor substrate 11.

The semiconductor substrate 11 includes a crystalline silicon material, such as single crystal silicon or polycrystalline silicon. The semiconductor substrate 11 is, for example, an n-type semiconductor substrate including a crystalline silicon material doped with an n-type dopant. The n-type dopant may be, for example, phosphorus (P). The semiconductor substrate 11 functions as a photoelectric conversion substrate to generate photocarriers (electrons and holes) when absorbing light incident on the light receiving surface. When the semiconductor substrate 11 is made of crystalline silicon, the dark current can be kept relatively low, and relatively high power (stable power regardless of illumination intensity) can be obtained even if the incident light has low intensity.

The semiconductor substrate 11 is one of pieces obtained by dividing a large semiconductor substate of a predetermined size. The predetermined size is a size determined depending on the given size of the semiconductor wafer (e.g., 6 inches). For example, a 6 inch large semiconductor substrate is divided into 4 or more and 10 or less pieces in a certain single direction.

The passivation layer 13 is provided on the light receiving surface of the semiconductor substrate 11. The passivation layer 23 is provided in the p-type region 7 on the back side of the semiconductor substrate 11. The passivation layer 33 is provided in the n-type region 8 on the back side of the semiconductor substrate 11. The passivation layers 13, 23, and 33 are made of, for example, an intrinsic (i-type) amorphous silicon material. The passivation layers 13, 23, and 33 suppress the recombination of carriers generated in the semiconductor substrate 11 to increase the carrier collection efficiency.

The antireflection layer 15 may be provided on the passivation layer 13 on the light receiving surface of the semiconductor substrate 11. The antireflection layer 15 is made of, for example, such a material as SiO, SiN, or SiON.

The p-type semiconductor layer 25 is provided on the passivation layer 23, namely, provided in the p-type region 7 on the back side of the semiconductor substrate 11. Specifically, as shown in FIG. 3 (and FIG. 1), the p-type semiconductor layer 25 has a so-called comb-shaped structure, which includes a plurality of teeth (branch pattern portions) 25f, which are like teeth of a comb, and a comb back portion (stem pattern portion) 25b, which is like a support for the teeth of a comb. An end of each of the teeth 25f is connected to the comb back portion 25b. The comb back portion 25b extends in the Y direction along one side of the semiconductor substrate 11. The teeth 25f extends in the X direction from the comb back portion 25b.

The n-type semiconductor layer 35 is provided on the passivation layer 33, namely, provided in the n-type region 8 on the back side of the semiconductor substrate 11. Specifically, as shown in FIG. 3 (and FIG. 1), the n-type semiconductor layer 35 has a so-called comb-shaped structure, which includes a plurality of teeth (branch pattern portions) 35f, which are like teeth of a comb, and a comb back portion (stem pattern portion) 35b, which is like a support for the teeth of a comb. An end of each of the teeth 35f is connected to the comb back portion 35b. The comb back portion 35b extends in the Y direction along another side of the semiconductor substrate 11. The teeth 35f extend in the X direction from the comb back portion 35b.

The comb back portions 25b and 35b have a width larger than that of the teeth 25f and 35f. This feature reduces the resistive loss of the comb back portion 25b, which collects currents from the teeth 25f, and reduces the resistive loss of the comb back portion 35b, which collects currents from the teeth 35f. This results in a reduction in the electrode resistance-induced power loss in the solar cell 2. The width of the comb back portions 25b and 35b refers to a width in a direction (X direction) intersecting their longitudinal direction (Y direction). The width of the teeth 25f and 35f refers to a width in a direction (Y direction) intersecting their longitudinal direction (X direction).

The p-type semiconductor layer 25 is made of, for example, an amorphous silicon material. The p-type semiconductor layer 25 is, for example, a p-type semiconductor layer including an amorphous silicon material doped with a p-type dopant. The p-type dopant may be, for example, boron (B). The n-type semiconductor layer 35 is made of, for example, an amorphous silicon material. The n-type semiconductor layer 35 is, for example, an n-type semiconductor layer including an amorphous silicon material doped with an n-type dopant (e.g., phosphorus (P) shown above).

The transparent electrode layer 27 is provided on the p-type semiconductor layer 25, namely, provided in the p-type region 7 on the back side of the semiconductor substrate 11. The transparent electrode layer 37 is provided on the n-type semiconductor layer 35, namely, provided in the n-type region 8 on the back side of the semiconductor substrate 11. The transparent electrode layers 27 and 37 are made of a transparent electrically-conductive material. Examples of the transparent electrically-conductive material include indium tin oxide (ITO, a complex oxide of indium oxide and tin oxide) and the like.

The first electrode layer 28 is provided on the transparent electrode layer 27, namely, provided in the p-type region 7 on the back side of the semiconductor substrate 11. Specifically, as shown in FIG. 3 (and FIG. 1), the first electrode layer 28 has a so-called comb-shaped structure, which includes a plurality of finger electrodes (branch pattern electrodes) 28f, which are like teeth of a comb, and a busbar electrode (stem pattern electrode) 28b, which is like a support for the teeth of a comb. An end of each of the finger electrodes 28f is connected to the busbar electrode 28b. The busbar electrode 28b, which is for the comb back portion 25b of the p-type semiconductor layer 25, extends in the Y direction along one side of the semiconductor substrate 11 at one end in the X direction. The finger electrodes 28f, which are for the teeth 25f of the p-type semiconductor layer 25, extend in the X direction from the busbar electrode 28b.

The second electrode layer 38 is provided on the transparent electrode layer 37, namely, provided in the n-type region 8 on the back side of the semiconductor substrate 11. Specifically, as shown in FIG. 3 (and FIG. 1), the second electrode layer 38 has a so-called comb-shaped structure, which includes a plurality of finger electrodes (branch pattern electrodes) 38f, which are like teeth of a comb, and a busbar electrode (stem pattern electrode) 38b, which is like a support for the teeth of a comb. An end of each of the finger electrodes 38f is connected to the busbar electrode 38b. The busbar electrode 38b, which is for the comb back portion 35b of the n-type semiconductor layer 35, extends in the Y direction along one side of the semiconductor substrate 11 at another end in the X direction. The finger electrodes 38f, which are for the teeth 35f of the n-type semiconductor layer 35, extend in the X direction from the busbar electrode 38b.

In the first electrode layer 28, the busbar electrode 28b includes a pad electrode 28p, to which one end of the connecting member 6 is to be connected. In the second electrode layer 38, at least one of the finger electrodes 38f includes a pad electrode 38p, to which the other end of the connecting member 6 is to be connected.

The first electrode layer 28 and the second electrode layer 38 are made of a metal material. Examples of the metal material that may be used include Cu, Ag, Al, and alloys of these metals. The first electrode layer 28 and the second electrode layer 38 may be formed using, for example, an electrically-conductive paste material containing a powder of metal, such as silver. Hereinafter, the details of the solar cell device 1 and the solar cell 2 will be described.

### Details of Solar Cell Device and Solar Cell

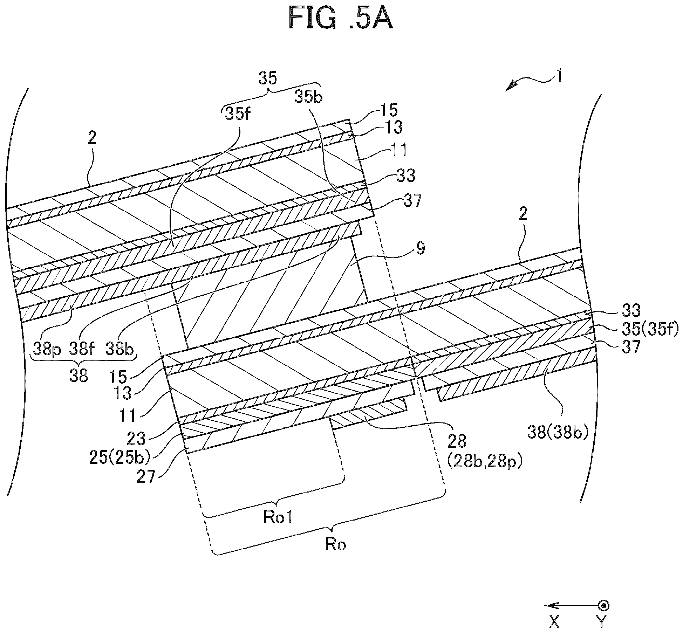

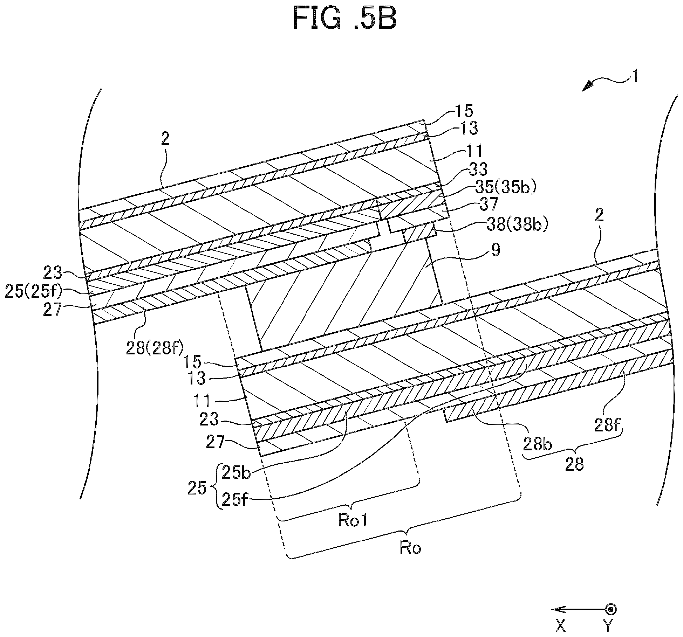

FIG. 5A is an enlarged cross-sectional view of a portion at and near the overlap region Ro of the solar cell device 1 shown in FIG. 2, which is substantially along the line IVA-IVA shown in FIG. 3. FIG. 5B is an enlarged cross-sectional view of a portion at and near the overlap region Ro of the solar cell device 1 shown in FIG. 2, which is substantially along the line IVB-IVB shown in FIG. 3. As shown in FIGS. 5A, 5B, 3, 4A, and 4B, the overlap region Ro at one end portion (a left end portion in each drawing) of the solar cell 2 includes a non-electrode region Ro1.

On the back side of the solar cell 2, the non-electrode region Ro1 at one end portion of the solar cell 2 has no electrode, such as the busbar electrode 28b and the pad electrode 28p for the first electrode layer 28. As used herein, the expression "having no electrode" means that there is no metal electrode layer for functioning to collect a current output from the solar cell 2. In other words, the non-electrode region may have a metal electrode layer for a function other than the collection of an output current, such as marking.

The non-electrode region Ro1 has a length from the long side at one end in the X direction of the solar cell 2, which is equal to 5% or more and 50% or less of the entire length of the short side of the solar cell 2 (the length in the X direction). The non-electrode region Ro1 has another length with reference to the center of the long side of the solar cell 2 (the center in the Y direction), which is equal to 60% or more and 100% or less of the entire length of the long side of the solar cell 2 (the length in the Y direction). In other words, the non-electrode region Ro1 is defined by a longitudinal dimension, which corresponds to a first length L1 equal to 60% or more and 100% or less of the entire length of the long side of the solar cell 2 (the length in the Y direction), and a transverse dimension, which corresponds to a second length L2 equal to 5% or more and 50% or less of the entire length of the short side of the solar cell 2 (the length in the X direction). In the defined non-electrode region Ro1, the center of the first length L1 (the longitudinal dimension) is the center of the long side of the solar cell 2 (the center in the Y direction), and the second length L2 (the transverse dimension) is from the long side at one end in the X direction of the solar cell 2.

The non-electrode region Ro1 having no metal electrode layer may be a single continuous region or may include a plurality of island (discontinuous) regions. The size (e.g., total area) of the non-electrode region Ro1 may be 20% or more and 100% or less, preferably 50% or more and 95% or less, and even more preferably 70% or more and 90% or less of the size (e.g., total area) of the overlap region Ro.

A portion or the whole of the busbar electrode (stem patten electrode) 28b and pad electrode 28p of the first electrode layer 28 are disposed in the overlap region Ro except for the non-electrode region Ro1. Specifically, the busbar electrode 28b and pad electrode 28p of the first electrode layer 28 are provided adjacent to the non-electrode region Ro1 in the overlap region Ro at one end portion on the back side.

The comb back portion (stem pattern portion) 25b of the p-type semiconductor layer 25 is located at one end portion in the X direction of the solar cell 2 (e.g., at a left end portion in FIGS. 2, 5A, and 5B). A portion or the whole of the comb back portion (stem pattern portion) 25b of the p-type semiconductor layer 25 is located in the overlap region Ro including the non-electrode region Ro1. The overlap region Ro has a width of 0.5 mm or more in the X direction.

The non-electrode region Ro1 may have the passivation layer 23, the p-type semiconductor layer 25, and the transparent electrode layer 27 at one end portion on the back side of the solar cell 2. This eliminates the need for a patterning mask for the formation of these layers. The transparent electrode layer 27 in the non-electrode region Ro1 improves the moisture resistance.

As described above, in the solar cell device 1 and the solar cell module 100 according to this embodiment, the solar cells 2 are electrically connected in a shingling manner such that a light receiving side portion of one of the adjacent solar cells 2 on one end side in the X direction (e.g., the left end side in FIGS. 2, 5A, and 5B) is disposed under a back side portion of the other solar cell 2 on another end side in the X direction (e.g., the right end side in FIGS. 2, 5A, and 5B). This feature makes it possible to mount more solar cells 2 in a limited area in the solar cell device 1 and the solar cell module 100, which increases the light receiving area for photoelectric conversion and increases the power of the solar cell device 1 and the solar cell module 100. There is also no space between the solar cells 2, which improves the design of the solar cell device 1 and the solar cell module 100.

In this embodiment, the solar cell device 1 and the solar cell module 100 include back electrode-type (back junction) solar cells. This feature keeps electrodes and wiring out of view and thus further improves the design of the solar cell device 1 and the solar cell module 100.

In the solar cell device 1 and the solar cell module 100 according to this embodiment, the comb back portion (stem pattern portion) 25b of the p-type semiconductor layer 25, which provides a power generation efficiency lower than that provided by the n-type semiconductor layer 35, is located at one end portion of the solar cell 2 (e.g., the left end in FIGS. 2, 5A, and 5B), and a portion or the whole of the comb back portion (stem pattern portion) 25b of the p-type semiconductor layer 25 is located in the overlap region Ro, in which portions of the adjacent solar cells 2 overlap each other. In other words, a portion or the whole of the comb back portion (stem pattern portion) 25b of the p-type semiconductor layer 25 in one of the adjacent solar cells 2 is disposed under a portion of the other solar cell 2 in the overlap region Ro. This feature increases the photoelectric conversion efficiency and power of the solar cell device 1 and the solar cell module 100.

For example, the present inventors have found that an edge portion with a length of up to 0.5 mm from the edge of a large semiconductor substrate provides a photoelectric conversion efficiency lower than that provided by other inner portions. In the solar cell device 1 and the solar cell module 100 according to this embodiment, the solar cells 2 are rectangular having a long side in a direction (Y direction) intersecting the direction (X direction) in which the solar cells 2 are arranged, and the overlap region Ro has a width of 0.5 mm or more in the X direction. This feature is highly effective in reducing the electrode resistance-induced power loss in the solar cells 2 and in suppressing the reduction in the photoelectric conversion efficiency of the solar cells 2, which is caused by the low photoelectric conversion efficiency of an edge portion of the large semiconductor substrate.

In the solar cell device 1 and the solar cell module 100 according to this embodiment, the semiconductor substrate 11 is one of pieces obtained by dividing a large semiconductor substate of a predetermined size, and an edge portion of such a large semiconductor substrate is located at one end portion of the solar cell 2 and located in the overlap region Ro. In this arrangement, therefore, one end portion of the solar cell 2, which corresponds to an edge portion of the large semiconductor substrate, is concealed, so that the solar cell device 1 and the solar cell module 100 have improved photoelectric conversion efficiency.

As mentioned above, a large semiconductor substrate is divided into pieces in a predetermined single direction, and one of the pieces is used as the semiconductor substrate 11 for the solar cell 2. Such a large semiconductor substrate has cutouts at its four corners. In the solar cell device 1 and the solar cell module 100 according to this embodiment, such cutouts are located in the overlap region Ro between the solar cells 2, which are each rectangular, having a long side along a direction (Y direction) intersecting the direction (X direction) in which the solar cells 2 are arranged. Thus, even when the solar cell 2 used has cutouts at its four corners, the cutouts can be located under the adjacent solar cell 2. This keeps the cutouts out of view from the light receiving side, which improves the design of the solar cell device 1 and the solar cell module 100.

In the solar cell device 1 and the solar cell module 100 according to this embodiment, the overlap region Ro, which is shielded from light at one end of the solar cell 2, has the non-electrode region Ro1 in the vicinity of its edge, in which no electrode is provided. This feature reduces the electrode resistance-induced power loss in the solar cell 2. When the shingling process is used to connect the solar cells 2, this feature also suppresses the reduction in the photoelectric conversion efficiency of the solar cell 2, which would otherwise be caused by a dark current generated in the overlap resin Ro shielded from light at one end. This results in an increase in the power of the solar cell device 1 and the solar cell module 100.

As mentioned above, the non-electrode region Ro1 may have the transparent electrode layer 27 as long as it has no metal electrode layer, such as the first electrode layer 28. Even if the transparent electrode layer is provided in the non-electrode region Ro1, the non-electrode region Ro1 can be expected to be somewhat effective in suppressing the reduction in the photoelectric conversion efficiency caused by a dark current in the overlap region Ro. If the non-electrode region Ro1 is also free of any transparent electrode layer, the reduction in the photoelectric conversion efficiency caused by a dark current in the overlap region Ro would be expected to be more effectively suppressed. Moreover, if the non-electrode region Ro1 has no transparent electrode layer, degradation of passivation can be prevented, which would otherwise be caused by deposition of a transparent electrode layer. In this regard, however, if the non-electrode region Ro1 has no transparent electrode layer, the moisture resistance, which has a trade-off relationship with suppression of passivation degradation, will be lower.

While an embodiment of the present invention has been described, it will be understood that the above embodiment is not intended to limit the present invention and may be altered or modified in various ways. For example, the above embodiment shows, by way of example, the solar cell device 1 including the solar cells 2 each including the semiconductor substrate 11 of n-type including a crystalline silicon material doped with an n-type dopant. Such an example is a non-limiting example, and the present invention is also applicable to solar cell devices including various other solar cells, such as solar cells including a p-type semiconductor substrate including a crystalline silicon material doped with a p-type dopant.

The embodiment shows, as a non-limiting example, the solar cell 2 including a crystalline silicon material. For example, various other materials, such as gallium arsenic (GaAs), may be used for solar cells.

As shown in FIGS. 4A and 4B, the embodiment shows, by way of example, the solar cell device 1 including the solar cells 2 of heterojunction type. Such an example is a non-limiting example, and the present invention is also applicable to solar cell devices including various other solar cells, such as homojunction type solar cells.

The embodiment shows, by way of example, the solar cell device 1 having the insulating member 9 provided between the adjacent solar cells 2. Alternatively, the insulating member 9 may be absent between the adjacent solar cells 2 in the solar cell device.

The embodiment shows, by way of example, the solar cell module 100 including a single solar cell device 1. Alternatively, the solar cell module 100 may include a plurality of solar cell devices 1 arranged, for example, in the Y direction.

### EXAMPLES

Hereinafter, the present invention will be more specifically described with reference to the examples below, which are not intended to limit the present invention.

### Example 1

The solar cells 2 shown in FIGS. 3, 4A, and 4B were fabricated for Example 1. The solar cells 2 for Example 1 are mainly composed as follows.
First conductivity type semiconductor layer 25: p-type semiconductor layer
Second conductivity type semiconductor layer 35: n-type semiconductor layer
Width of non-electrode region Ro1: 0.5 mm
Width of pad electrode 28p and busbar electrode 28b: 1.0 mm

The solar cell device 1 shown in FIGS. 1 and 2 was then fabricated as Example 1 such that the comb back portion (stem pattern portion) 25b of the p-type semiconductor layer 25 at one end of one of the adjacent solar cells 2 was overlapped (concealed) under another end portion of the other solar cell 2. In the solar cell device 1 of Example 1, the width of the overlap region Ro at one end portion of the solar cell 2 was variable from 0.0 mm to 1.0 mm, 1.5 mm, or 2.0 mm.

### Comparative Example 1

Solar cells for Comparative Example 1 were fabricated similar to those for Example 1 except for the features shown below.
First conductivity type semiconductor layer 25: n-type semiconductor layer
Second conductivity type semiconductor layer 35: p-type semiconductor layer

A solar cell device of Comparative Example 1 was then fabricated, similar to that of Example 1, such that the n-type semiconductor layer had a comb back portion (stem pattern portion) at one end of one of adjacent solar cells and the comb back portion was overlapped (concealed) under another end portion of the other solar cell. In the solar cell device of Comparative Example 1, the width of the overlap region at one end of the solar cell was also variable from 0.0 mm to 1.0 mm, 1.5 mm, or 2.0mm.

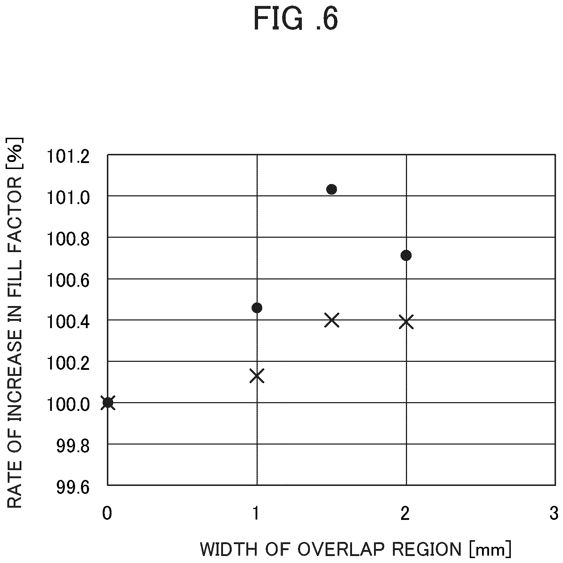

Regarding the power, the fill factor was measured of the solar cell modules of Example 1 and Comparative Example 1 fabricated as shown above. The results are shown in Table 1 and FIG. 6. Table 1 and FIG. 6 show the relative values of the fill factors of the solar cell devices of Example 1 and Comparative Example 1 with an overlap region Ro width of 1.0 mm, 1.5 mm, or 2.0 mm, which were calculated with the fill factors of the solar cell devices of Example 1 and Comparative Example 1 with an overlap region Ro width of 0.0 mm normalized to 100%. FIG. 6 also shows the fill factors of the solar cell devices (in the rate (%) of increase) versus the width of the overlap region between the solar cells. In FIG. 6, the solid circles (●) indicate the fill factors of the solar cell device of Example 1 (in the rate (%) of increase), and the cross marks (×) indicate the fill factors of the solar cell device of Comparative Example 1 (in the rate (%) of increase).

**[Table 1]**

| | Fill factor (rate (%) of increase) | | | |
|---|---|---|---|---|
| Width of overlap region | 0.0mm | 1.0mm | 1.5mm | 2.0mm |
| Example 1 (p-type semiconductor layer concealed) | 100.00% | 100.46% | 101.03% | 100.71% |
| Comparative Example 1 (n-type semiconductor layer concealed) | 100.00% | 100.14% | 100.40% | 100.39% |

Table 1 and FIG. 6 indicate that the fill factor of the solar cell device is higher when the solar cells are overlapped than when the solar cells are not overlapped (when the width of the overlap region is 0.0 mm). Moreover, the rate of increase in the fill factor of the solar cell device was the highest when all of the non-electrode region Ro1 (0.5 mm wide), the busbar electrode 28b, and the pad electrode 28p (1.0 mm wide) were disposed in the overlap region Ro. Furthermore, the rate of increase in the fill factor of the solar cell device was higher in Example 1 where the p-type semiconductor layer was concealed than in Comparative Example 1 where the n-type semiconductor layer was concealed.

### EXPLANATION OF REFERENCE NUMERALS

1: Solar cell device
2: Solar cell
3: Light receiving side protective member
4: Back side protective member
5: Sealant
6: Connecting member
7: p-Type region (first conductivity type region)
8: n-Type region (second conductivity type region)
7b, 8b: Comb back portion
7f, 8f: Tooth
9: Insulating member
11: Semiconductor substrate
13, 23, 33: Passivation layer
25: p-Type semiconductor layer (first conductivity type semiconductor layer)
25b: Comb back portion (stem pattern portion)
25f: Tooth (branch pattern portion)
27: Transparent electrode layer
28: First electrode layer
28b: Busbar electrode (stem pattern electrode)
28f: Finger electrode (branch patten electrode)
28p: Pad electrode
35: n-Type semiconductor layer (second conductivity type semiconductor layer)
35b: Comb back portion (stem pattern portion)
35f: Tooth (branch pattern portion)
37: Transparent electrode layer
38: Second electrode layer
38b: Busbar electrode (stem pattern electrode)
38f: Finger electrode (branch pattern electrode)
38p: Pad electrode
100: Solar cell module
Ro: Overlap region
Ro1: Non-electrode region

## Claims

1. A solar cell device comprising a plurality of solar cells connected electrically,
adjacent solar cells of the plurality of solar cells being overlapped in such a manner that a portion of one of the adjacent solar cells, which is at one end portion and on one main surface, is disposed under a portion of another of the adjacent solar cells, which is at another end portion opposite to the one end portion and on another main surface opposite to the one main surface,
each of the plurality of solar cells being a back junction solar cell comprising: a semiconductor substrate; a p-type semiconductor layer provided in a portion on the another main surface of the semiconductor substrate; and an n-type semiconductor layer provided in another portion on the another main surface of the semiconductor substrate,
each of the p-type semiconductor layer and the n-type semiconductor layer including a plurality of branch pattern portions and a stem pattern portion to which an end of each of the branch pattern portions is connected,
the stem pattern portion of the p-type semiconductor layer being disposed at the one end portion of each of the solar cells, and
the stem pattern portion of the p-type semiconductor layer being partially or entirely disposed in an overlap region in which portions of the adjacent solar cells overlap.

2. The solar cell device according to claim 1, wherein the stem pattern portion of the p-type semiconductor layer has a width larger than that of each of the branch pattern portions.

3. The solar cell device according to claim 1 or 2, wherein
each of the plurality of solar cells includes a first electrode layer for the p-type semiconductor layer; and a second electrode layer for the n-type semiconductor layer,
the first and second electrode layers each include branch pattern electrodes for the branch pattern portions and a stem pattern electrode for the stem pattern portion, and an end of each of the branch pattern electrodes is connected to the stem pattern electrode, and
the stem pattern electrode of the first electrode layer is partially or entirely located in the overlap region.

4. The solar cell device according to any one of claims 1 to 3, further comprising an electrically-conductive connecting member provided across the adjacent solar cells to electrically connect the adjacent solar cells.

5. The solar cell device according to claim 3, wherein
the overlap region includes a non-electrode region that is free of the stem pattern electrode of the first electrode layer at the one end portion and on the another main surface of the solar cell, and
in the non-electrode region, the p-type semiconductor layer is provided at the one end portion and on the another main surface of the solar cell.

6. The solar cell device according to claim 3 or 5, wherein
the overlap region includes a non-electrode region that is free of the stem pattern electrode of the first electrode layer at the one end portion and on the another main surface of the solar cell, and
in the non-electrode region, a transparent electrode layer is provided at the one end portion and on the another main surface of the solar cell.

7. The solar cell device according to any one of claims 3, 5, and 6, wherein
the overlap region includes a non-electrode region that is free of the stem pattern electrode of the first electrode layer at the one end portion and on the another main surface of the solar cell, and
in the non-electrode region, a passivation layer is provided at the one end portion and on the another main surface of the solar cell.

8. The solar cell device according to any one of claims 1 to 7, wherein
each of the solar cells is rectangular having a long side along a direction intersecting a direction in which the solar cells are arranged, and
the overlap region has a width of 0.5 mm or more.

9. The solar cell device according to any one of claims 1 to 8, wherein
each of the solar cells is rectangular having a long side along a direction intersecting a direction in which the solar cells are arranged,
the semiconductor substrate has cutouts at both ends of the long side, and
the cutouts are located in the overlap region.

10. The solar cell device according to any one of claims 1 to 9, wherein
the semiconductor substrate is one of pieces obtained by dividing a large semiconductor substrate of a predetermined size, and
an edge portion of the large semiconductor substrate is located at the one end portion of the solar cell and located in the overlap region.

11. A solar cell module comprising the solar cell device according to any one of claims 1 to 10.
